# EUROPEAN PATENT APPLICATION

(11) **EP 1 172 860 A2**
(43) Date of publication of application: **16.01.2002**
(21) Application number: 01116415.9
(22) Date of filing: 06.07.2001
(51) Int. Cl.: H01L 29/778

(54) **Hemt device with a buffer to channel insert layer**

(30) Priority: 14.07.2000 US 616351
(71) Applicant: TRW INC., Redondo Beach, CA 90278 (US)
(72) Inventor: Wojtowicz, Michael, Long Beach, CA 90815 (US); Chin, Tsung-Pei, Marina Del Rey, CA 90292 (US); Barsky, Michael E., Sherman Oaks, CA 91401 (US); Grundbacher, Ronald W., Hermosa Beach, CA 90254 (US); Streit, Dwight C., Seal Beach, CA 90740 (US); Lai, Richard, Redondo Beach, CA 90277 (US)
(74) Representative: Schmidt, Steffen J., Dipl.-Ing.

(57) **Abstract**

A HEMT device having an insert layer between the buffer layer and the channel. The HEMT device comprises a buffer layer having a lattice constant and being disposed on a substrate. A channel having a lattice constant is disposed over the buffer layer and an insert layer having a lattice constant is disposed between the buffer layer and the channel with the lattice constant of the insert layer being intermediate the lattice constant of the buffer layer and the channel. The insert layer provides for a HEMT device having a decreased sensitivity to impurities in the deposition system and provides for an easier interface upon which to grow the channel.

## Description

### BACKGROUND OF THE INVENTION

The present invention relates generally to High Electron Mobility Transistor (HEMT) devices and more particularly, to a HEMT device having an insert layer between the buffer layer and the channel.

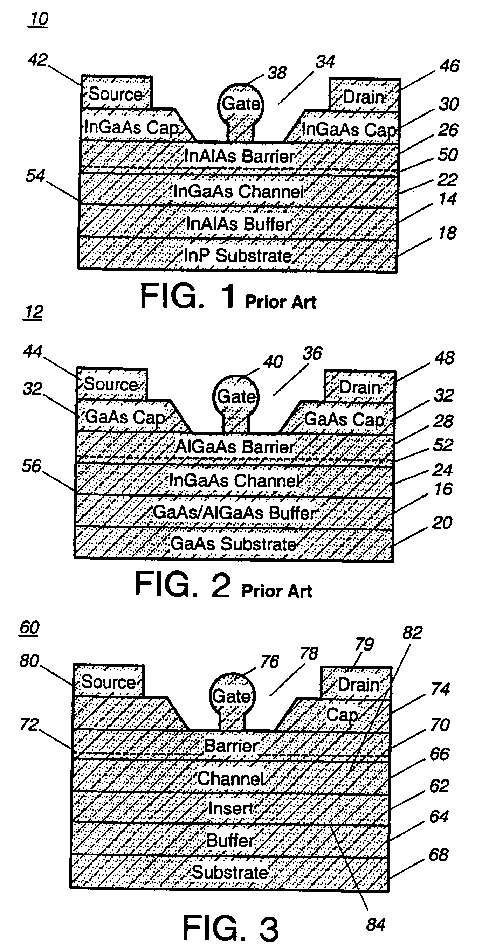

FIGs. 1 & 2 show typical prior art indium phosphide (InP) based 10 and gallium arsenide (GaAs) 12 based HEMT devices. Each HEMT device 10, 12 comprises a buffer layer 14, 16 grown on a substrate 18, 20. A channel layer 22, 24 is grown on each buffer layer 14, 16 and a barrier layer 26, 28 is grown over each channel layer 22, 24. Cap layers 30, 32 are grown over the barrier layers 26, 28 and a portion of each cap layer 30, 32 is removed to form recesses 34, 36 in the cap layers 30, 32. A gate 38, 40 is positioned in each recess 34, 36, and source 42, 44 and drain 46, 48 contacts are deposited on either side of the gates 38, 40 on the cap layers 30, 32, respectively.

For the typical prior art InP HEMT device 10 of FIG. 1, the substrate 18 is fabricated of an InP material and the buffer layer 14 is fabricated of an indium aluminum arsenide (InAlAs) material. The channel 22 is fabricated of an indium gallium arsenide (InGaAs) material comprising greater than 52% of indium. The barrier layer 26 is fabricated of an InAlAs material and typically includes silicon (Si) planar doping 50 near the channel 22. The cap 30 is fabricated of an InGaAs material.

For the typical prior art GaAs HEMT device 12 of FIG. 2, the substrate 20 is fabricated of a GaAs material and the buffer layer 16 is fabricated of both a GaAs and aluminum gallium arsenide (AlGaAs) material where the GaAs material is near the substrate 20 and the AlGaAs material is near the channel 24. The channel 24 is fabricated of an InGaAs material and the barrier layer 28 is fabricated of an AlGaAs material. The barrier layer 28 typically includes a Si doping layer 52, and, the cap 32 is fabricated of a GaAs material.

One disadvantage of prior art HEMT devices 10, 12 is that it is difficult to begin growth of the channels 22, 24 directly on the buffers 14, 16. This is primarily due to the large difference in lattice constants between the buffers 14, 16 and the channels 22, 24. This large difference in the lattice constants results in a rough interface 54, 56 between each buffer layer 14, 16 and the associated channels 22, 24. The rough interfaces 54, 56 can cause defects or traps between the buffer layers 14, 16 and the channels 22, 24 reducing the electrical performance of the associated HEMT device 10, 12.

A second disadvantage of the prior art HEMT devices 10, 12 is that the performance of the HEMT device 10, 12 is very dependant on the cleanliness of the system in which the HEMT device 10, 12 is grown. Typically, HEMT devices 10, 12 are grown by methods such as molecular beam epitaxy (MBE) in a vacuum environment which is ideally free of impurities. Realistically however, it is extremely difficult and very expensive to provide a vacuum environment which is totally free of all impurities. This results in variability in the performance of the HEMT devices 10, 12 because the impurities, particular oxygen, incorporate into the buffer layers 14, 16 and can adversely effect the transport of electrons in the channels 22, 24.

What is needed therefore is a method for producing a HEMT device which provides for ease of growth of the channel and additionally is less sensitive to imperfections in the growth process than prior art HEMT devices.

### SUMMARY OF THE INVENTION

The proceeding and other shortcomings of the prior art are addressed and overcome by the present invention which provides a HEMT device and a method for fabricating a HEMT device having an insert layer between the buffer layer and the channel which reduces the channel's sensitivity to impurities in the deposition system and provides an easier interface upon which to grow the channel.

The method comprises disposing a buffer layer having a lattice constant on a substrate. A channel having a lattice constant is disposed over the buffer layer; and, an insert layer having a lattice constant is disposed between the buffer layer and the channel with the lattice constant of the insert layer selected to be intermediate the lattice constant of the buffer layer and the channel. A barrier layer is disposed on the channel and a cap layer is disposed on the barrier layer. A recess is formed in the cap layer exposing the barrier layer and a gate is positioned on the exposed portion of the barrier layer. To complete the HEMT device, a source and the drain are positioned on the cap.

In a second aspect, the present invention provides a HEMT device having a gate, a source and a drain. A buffer layer having a lattice constant is disposed on a substrate. An insert layer having a lattice constant greater than the lattice constant of the buffer layer is disposed on the buffer layer. A channel having a lattice constant greater than the lattice constant of the insert layer is disposed on the insert layer. A barrier layer is disposed over the channel layer and, a cap is deposited on the barrier layer. To complete the HEMT device, the gate is disposed on a portion of the barrier layer through a recess in the cap and, a source and a drain are disposed on the cap.

### BRIEF DESCRIPTION OF THE DRAWINGS

Reference is now made to the detailed description of the preferred embodiments, illustrated in the accompanying drawings, in which:
FIG 1 shows a cross-sectional view of an InP based HEMT device in accordance with the prior art;
FIG. 2 shows a cross-sectional view of a GaAs based HEMT device in accordance with the prior art;
FIG. 3 shows a cross-sectional view of a HEMT device having an insert layer in accordance with a first embodiment of the present invention;
FIG. 4 shows a cross-sectional view of a portion of a InP-based HEMT device with a InGaAs insert layer in accordance with a second embodiment of the present invention; and,
FIG. 5 shows a cross-sectional view of a portion of an GaAs-based HEMT device having a GaAs insert layer in accordance with a third embodiment of the present invention.

### DETAILED DESCRIPTION OF THE PREFERRED EMBODIMENTS

Referring to FIG. 3, the present invention provides a HEMT device 60 which addresses and overcomes the disadvantages of the prior art by providing an insert layer 62 between the buffer layer 64 and the channel 66. The buffer layer 64 is disposed on the substrate 68 and the insert layer 62 is disposed on the buffer layer 64. The channel 66 is disposed on the insert layer 62 and a barrier layer 70 is disposed on the channel 66. The barrier layer 70 preferably includes a doping layer 72 near the channel 66 where the doping layer 72 is preferably a Si planar doping layer. A cap 74 is disposed on the barrier layer 70. To complete the HEMT device 60, a gate 76 is disposed on the barrier layer 70 through a recess 78 in the cap layer 74, and a drain 79 and a source 80 are disposed on the cap 74. The layers 62-70 & 74, gate 76, drain 78 and source 80 are preferably disposed by a depositing method or a growth method known to one skilled in the art.

The insert layer 62 is a lattice constant transition layer which, when grown on the buffer layer 64, provides a surface 82 having a larger lattice constant for the channel 66 to be deposited on than that provided by the buffer layer 64. The material for the insert layer 62 is selected so that the lattice constant of the insert layer 62 is between the lattice constant of the buffer layer 64 and the lattice constant of the channel 66. Preferably, the material for the insert layer 62 is selected so that the lattice constant of the insert layer 62 is approximately halfway between the lattice constants of the buffer layer 64 and the channel 66. Selecting the material for the insert layer 62 to have a lattice constant between that of the buffer layer 64 and the channel 66 provides a surface 82 with a lattice constant closer to that of the channel 66 than the lattice constant provided by the buffer layer 64. As such, the channel 66 can be grown with better crystal quality when grown on the larger lattice constant of the insert layer 62 than on the lattice constant of the buffer layer 64.

In addition to providing a better surface to grow the channel 66 upon, selecting a material for the insert layer 62 to have a lattice constant between that of the buffer layer 64 and the channel layer 66 results in the insert layer 62 having a conduction band energy (CBE) which is greater than the CBE of the channel 66. Conduction band energy (CBE) is known to define how the electrons in the HEMT device 60 will respond to a voltage applied across the device 60. In a HEMT device 60, the electrons will move towards the layer having the lowest CBE. To provide a HEMT device 60 in which most of the electrons flow in the channel 66, the CBE of the channel 66 must be lower than the CBE of the insert layer 62. As such, the present invention provides for the desirable property that most of the electrons in the HEMT device 60 will flow in the channel 66.

The insert layer 62 also provides a surface 82 which is less prone to impurities during a deposition or growth process than the surface 84 of the buffer layer 64. As previously mentioned, layers 62-70 & 74 are typically disposed by a deposition system, such as an MBE system. As such, the cleanliness of the deposition system can vary significantly and the defects in the buffer layer 64 can vary significantly with minor effect on the performance of the channel 66. The surface 82 of the insert layer 62 is less susceptible to impurities in an MBE vacuum environment because the insert layer 62 either does not contain aluminum or has a lower aluminum content than the buffer layer 64. As such, the insert layer 62 is much less susceptible to the impurities in the deposition system. This results in more repeatable channel characteristics from one HEMT device to another HEMT device in a production environment.

For the preferred embodiment of the invention, the insert layer 42 is limited to a thickness of about 1-10 nm since after about 10 nm, the insert layer 42 begins to adversely effect the ability to control the electrons in the channel 46 which can decrease the electrical characteristics of the channel 46. A HEMT device is a controlled electron device and, as such, it is important to control the flow of the electrons in the channel 46. It is easier to control the electrons if they are concentrated together in a narrower channel. Simulations have shown that an unacceptable loss of control of the electrons in the channel 46 exists once the insert layer 42 is wider than about 10 nm.

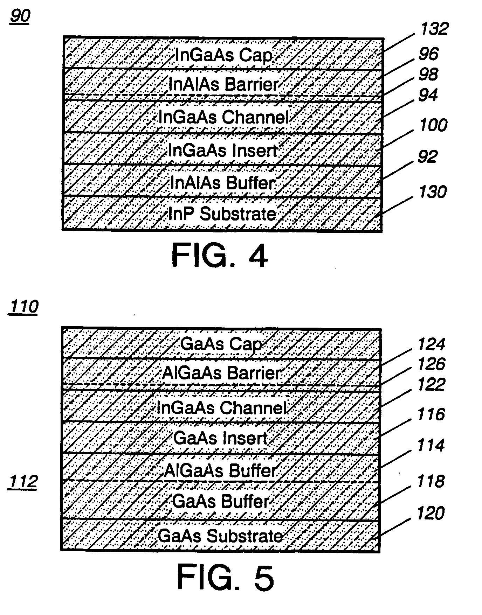

The exact material selected for the insert layer 62 is dependent on the materials used for the buffer layer 64 and the channel 66. For example, referring to FIG. 4, for an InP based HEMT device 90, the buffer layer 92 is fabricated of an InAlAs material and the channel 94 is fabricated of an InGaAs material. The barrier layer 96 is fabricated of an InAlAs material and includes a Si planar doping layer 98 which is deposited near the channel 94. Note that the gate, source and drain of a HEMT device are typically omitted from cross-sectional views of a HEMT device. In accordance with this practice, the gates, sources and drains will not be shown in subsequent cross-sectional drawings of HEMT devices. However, it is understood that each HEMT device includes a gate, a source and a drain. For InP HEMT device 90 shown in FIG. 4, the insert layer 100 is preferably fabricated of an InGaAs material comprising no more than 53% Indium. This InGaAs material has a lattice constant which is between that of the InAlAs buffer layer 92 and the InGaAs channel 94.

As another example, referring to FIG. 5, for a GaAs-based HEMT device 110, the buffer layer 112 is comprised of GaAs/AlGaAs materials with the AlGaAs portion 114 of the buffer layer 112 deposited nearest the insert layer 116 and the GaAs portion 118 of the buffer layer 112 deposited nearest the substrate 120. The channel 122 is fabricated of an InGaAs material and the barrier layer 124 is fabricated of an AlGaAs material and includes a Si planar doping layer 126 near the channel 122. For this GaAs HEMT device 110, the insert 116 is preferably fabricated of a GaAs material having a lattice constant which is greater than the lattice constant of the AlGaAs portion 114 of the buffer layer 112 and smaller than the lattice constant of the InGaAs material of the channel 122.

An InP based HEMT device having an insert layer in accordance with the present invention was fabricated and tested. Referring back to FIG. 4, the buffer layer 92 was fabricated of an InAlAs material to a thickness of 300 nm. The insert layer 100 was fabricated of 10 nm thick InGaAs material which was lattice matched to the InP substrate 130. The channel 94 was fabricated of 20 nm thick InGaAs material which comprised greater than 53% Indium. The barrier layer 96 was fabricated of 28 nm thick InAlAs material which included a Si planar doping layer 98 near the channel 94. The cap 132 was fabricated of 20 nm thick InGaAs material. The transconductance and gain of this fabricated HEMT device were measured at a frequency of 190 GHz. When compared to a HEMT device without an insert, the fabricated HEMT device provided better confinement of the electrons in the channel 94 and measured an approximately 15% improvement in the transconductance which translates to a 2.8 dB increase in gain.

As will be appreciated by one skilled in the art, the present invention is not limited to the structures and figures shown and described hereinabove but can be practiced with any HEMT device in which the lattice constant of the buffer layer is lower than the lattice constant of the channel. It will be appreciated that many variations of the invention are possible and the invention is not limited only by the claims which follow.

## Claims

1. A method for fabricating a HEMT device comprising the steps of:
disposing a buffer layer having a lattice constant on a substrate;
disposing an insert layer having a lattice constant greater than the lattice constant of the buffer layer over said buffer layer;
disposing a channel having a lattice constant greater than the lattice constant of the insert layer on the insert layer;
disposing a barrier layer over said channel layer;
disposing a cap on said barrier layer;
exposing a portion of said barrier layer;
disposing a gate on the exposed portion of the barrier layer; and,
disposing a gate and a source on said cap.

2. The method of claim 1, wherein exposing a portion of said barrier layer comprises removing a portion of said cap to expose a portion of said barrier layer.

3. The method of claim 1, wherein disposing a buffer layer comprises disposing a buffer layer having a lattice constant and a conduction band energy on a substrate;
disposing an insert layer comprises disposing an insert layer having a lattice constant greater than that of the buffer layer and a conduction band energy less than that of the buffer layer on said buffer layer; and,
disposing a channel comprises disposing a channel having a lattice constant greater than the lattice constant of the insert layer and a conduction band energy less than the conduction band energy of the insert layer over the insert layer.

4. The method of claim 1, wherein disposing a buffer layer comprises disposing a buffer layer fabricated of an InAlAs material having a lattice constant on a InP substrate;
disposing an insert layer comprises disposing an insert layer fabricated of InGaAs material lattice matched to said substrate on said buffer layer; and,
disposing a channel comprises disposing a channel of InGaAs material over said buffer layer.

5. The method of claim 1, wherein disposing a buffer layer comprises disposing a buffer layer fabricated of a GaAs/AlGaAs material on a GaAs substrate;
disposing an insert layer comprises disposing an insert layer fabricated of GaAs material lattice matched to said substrate on said buffer layer; and,
disposing a channel comprises disposing a channel comprises InGaAs having greater than 52% indium over said buffer layer.

6. A high electron mobility transistor (HEMT) device having a gate, source and drain comprising:
a buffer layer having a lattice constant and being disposed on a substrate;
an insert layer having a lattice constant greater than the lattice constant of the buffer layer and being disposed on said buffer layer;
a channel having a lattice constant greater than the lattice constant of insert layer and being disposed on said insert layer;
a barrier layer disposed over said channel; and,
a cap disposed over said barrier layer, wherein said gate is positioned on said barrier layer and said source and drain are positioned on said cap.

7. A HEMT device as in claim 6, wherein said gate is positioned on said barrier layer through a recess formed in said cap.

8. A HEMT device as in claim 6, wherein said buffer layer, channel and insert layer each have a conduction band energy, the conduction band energy of the insert layer being between that of the buffer layer and the channel.

9. A HEMT device as in claim 6, wherein said buffer layer comprises an InAlAs material, said channel comprises an InGaAs material, said insert layer comprises InGaAs material and said substrate comprise InP material.

10. A HEMT device as in claim 6, wherein said insert layer is fabricated of a material which is lattice matched to said substrate.

11. A HEMT device as in claim 6, wherein said buffer layer comprises an AlGaAs material, said channel comprises a GaAs/InGaAs material, said insert layer comprises a GaAs material; and, said substrate comprises a GaAs material.
